# EUROPEAN PATENT APPLICATION

(11) **EP 3 251 899 A1**
(43) Date of publication of application: **06.12.2017**
(21) Application number: 16743076.8
(22) Date of filing: 12.01.2016
(51) Int. Cl.: B60R 16/02, C09D 5/00, C09D 7/12, C09D 201/00, H05K 7/20

(54) **VEHICLE MOUNTED CONTROL APPARATUS**

(30) Priority: 30.01.2015 JP 2015016295
(71) Applicant: Hitachi Automotive Systems, Ltd., Hitachinaka-shi, Ibaraki 312-8503 (JP)
(72) Inventor: ITO Maki, Tokyo 100-8280 (JP); ISHII Toshiaki, Tokyo 100-8280 (JP); KAWAI Yoshio, Hitachinaka-shi Ibaraki 312-8503 (JP)
(74) Representative: MERH-IP Matias Erny Reichl Hoffmann Patentanwälte PartG mbB
(86) International application number: PCT/JP2016/050598
(87) International publication number: WO 2016/121472

(57) **Abstract**

Provided is an onboard control apparatus (ECU) having a thermal radiating coating film capable of efficiently radiating heat generated from an electronic component to the outside of the casing.

An onboard control apparatus includes: a circuit board stored in a housing; an electronic component mounted on the circuit board; and a thermal radiating coating film which is disposed on the electronic component to radiate heat generated from the electronic components, wherein the thermal radiating coating includes a resin and thermal radiating particles which radiate heat, and the thermal radiating particles and the resin have substantially same specific gravity.

## Description

### Technical Field

The present invention relates to an onboard control apparatus such as an ECU mounted on an automobile, and more particularly, to a thermal radiation structure of an electronic control apparatus having a thermal radiating coating film.

### Background Art

Recently, an onboard control apparatus (ECU) mounted on an automobile has been configured to usually include a circuit board on which electronic components including heat-generating components such as semiconductor elements are mounted, and a housing that stores the circuit board. In general, the housing includes a base which fixes the circuit board, and a cover assembled to the base so as to cover the circuit board.

In such an onboard control apparatus, in recent years, a heating value has tended to increase with downsizing due to restriction of a space and a multifunction. PTL 1 discloses a thermal radiation technique which performs a surface treatment on a housing in order to move heat generated by an electronic component (heating element) to the housing and radiate heat from the outer surface of the housing into the atmosphere.

Further, as disclosed in PTL 2, a thermal radiation method for forming a coating film on the surface of a thermal radiation member with a coating material containing ceramic particles is known.

### Citation List

### Patent Literature

PTL 1: Japanese Patent Application Laid-Open No. 2004-304200
PTL 2: Japanese Patent Application Laid-Open No. 2013-144746

### Summary of Invention

### Technical Problem

In recent years, there is a social demand to increase density and miniaturize an engine room from the viewpoint of resource saving and the like. Miniaturization also progresses in the onboard control apparatus, and the heat generation density increases with a reduction in a board area or a concentration of electronic components accordingly. Thus, further improvement of the thermal radiation properties is required.

In the conventional proposed technique, it is possible to improve the thermal radiation properties by applying the coating containing ceramic particles to the thermal radiation member. However, in order to satisfy the above requirement, it is desirable to further improve the thermal radiation properties. Also, although it is possible to improve the thermal radiation properties by increasing the content of the ceramic particles, the viscosity of the coating increases and the coating properties deteriorate. Although the ceramic particles can be diluted with a solvent to lower the viscosity, precipitation of the ceramic particles is promoted and separated.

The present invention has been made in view of the above circumstances, and an object thereof is to provide an onboard control apparatus equipped with a thermal radiating coating film capable of efficiently radiating heat generated from electronic components.

### Solution to Problem

In order to solve the above issue, an onboard control apparatus according to the present invention includes: a circuit board stored in a housing; an electronic component mounted on the circuit board; and a thermal radiating coating film which is disposed on the electronic component to radiate heat generated from the electronic components, wherein the thermal radiating coating includes a resin and thermal radiating particles which radiate heat, and the thermal radiating particles and the resin have substantially same specific gravity.

### Advantageous Effects of Invention

According to the invention, it is possible to provide an onboard control apparatus equipped with a thermal radiating coating film which has excellent coating properties and is capable of efficiently radiating heat generated from electronic components.

### Brief Description of Drawings

[FIG. 1] FIG. 1 is an exploded perspective view illustrating an example of an onboard control apparatus.
[FIG. 2] FIG. 2 is a cross-sectional view of the onboard control apparatus.
[FIG. 3] FIG. 3 is a cross-sectional view of a thermal radiating coating film of Example 1.
[FIG. 4] FIG. 4 is a cross-sectional view of a thermal radiating coating film of Example 2.
[FIG. 5] FIG. 5 is a cross-sectional view of a thermal radiating coating film of Example 3.
[FIG. 6] FIG. 6 is a cross-sectional view of a thermal radiating coating film of Example 4.

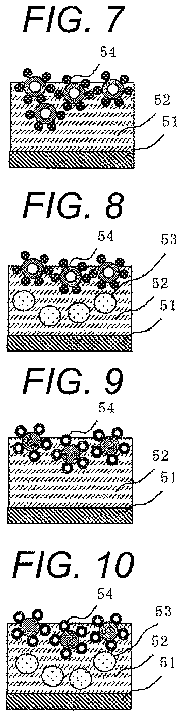

[FIG. 7] FIG. 7 is a cross-sectional view of a thermal radiating coating film of Example 5.
[FIG. 8] FIG. 8 is a cross-sectional view of a thermal radiating coating film of Example 6.
[FIG. 9] FIG. 9 is a cross-sectional view of a thermal radiating coating film of Example 7.
[FIG. 10] FIG. 10 is a cross-sectional view of a thermal radiating coating film of Example 8.

### Description of Embodiments

Hereinafter, embodiments of the present invention will be described with reference to the drawings as appropriate.

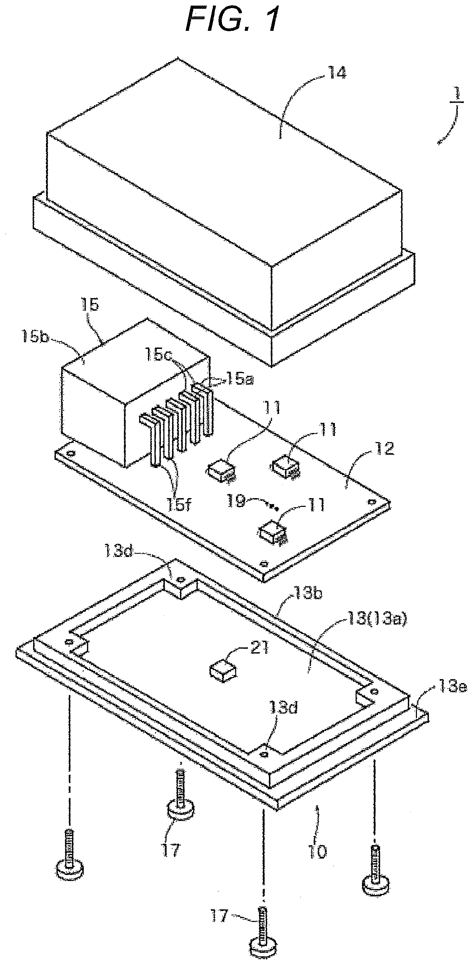

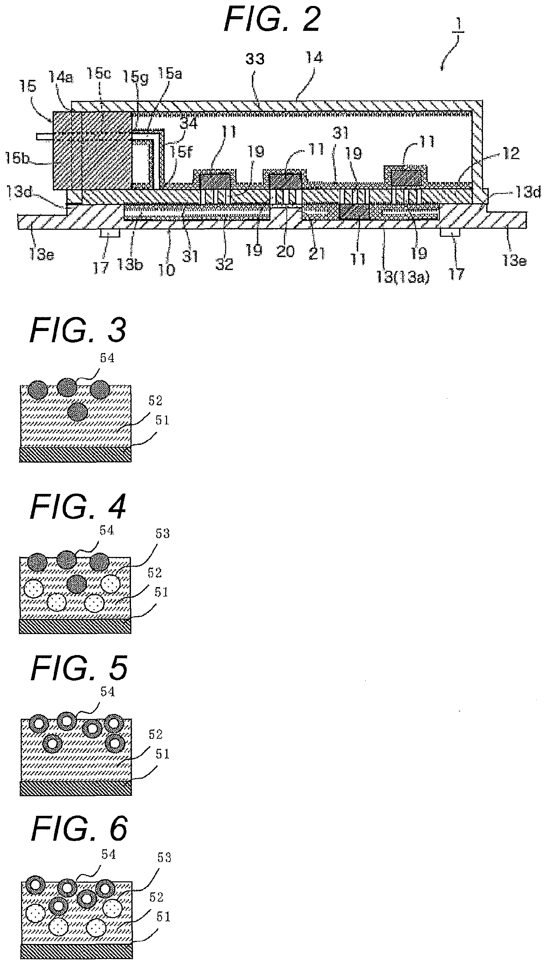

FIG. 1 is an example of an exploded perspective view illustrating a main configuration of an onboard control apparatus (ECU). FIG. 2 is a cross-sectional view of the onboard control apparatus in FIG. 1. As illustrated in FIGS. 1 and 2, the onboard control apparatus 1 is configured to include a circuit board 12 in which electronic components 11 such as ICs and semiconductor elements are mounted on both upper and lower (front and back) surfaces by solder, and a housing 10 in which the circuit board 12 is stored. The housing 10 includes a base 13 to which the circuit board 12 is fixed, and a box or lid cover 14 having an open lower surface which is assembled to the base 13 so as to cover the circuit board 12.

A connector 15 for electrically connecting the circuit board 12 to the outside is attached to one end side of the circuit board 12 in a longitudinal direction. The connector 15 is equipped with a required number of pin terminals 15a and a housing 15b provided with a through-hole 15c into which a pin terminal 15a is inserted by press fitting or the like. In the connector 15, after the pin terminal 15a is inserted into the through-hole 15c of the housing 15b, the lower end portion of the pin terminal 15a (the connection joint 15f) is connected and joined to the circuit board 12 by soldering through a spot flow process or the like.

The base 13 has a substantially rectangular flat plate shape as a whole so as to close a lower surface opening of the cover 14. Specifically, the base 13 includes a rectangular plate section 13a, a rectangular frame section 13b protruding from the rectangular plate section 13a, pedestals 13d provided on the four corners of the rectangular frame section 13b to serve as seating surfaces of the circuit board 12, and a vehicle assembly fixing section 13e extending on the outer periphery of the rectangular plate section 13a. The vehicle assembly fixing section 13e is configured to assemble the onboard control apparatus 1 to the body of the vehicle body, and is fixed, for example, by screwing bolts or the like to a predetermined position of the body of the vehicle body.

The base 13 and the cover 14 forming the housing 10 of the onboard control apparatus 1 are assembled by sandwiching the circuit board 12 to which the connector 15 is attached. More specifically, the circuit board 12 is fixed by a set screw 17 as an example of a fastening member, while being held between the pedestals 13d provided at the four corners of the base 13 and the cover 14.

The base 13 and the cover 14 forming the housing 10 of the onboard control apparatus 1 are assembled by sandwiching the circuit board 12 to which the connector 15 is attached. More specifically, the circuit board 12 is fixed by a set screw 16 as an example of a fastening member, while being held between the pedestals 13d provided at the four corners of the base 13 and the cover 14.

The base 13 and the cover 14 are manufactured by casting, pressing, or cutting using a metal material or a resin material. More specifically, the base 13 and the cover 14 are manufactured by casting, pressing, or cutting using a resin material such as an alloy containing aluminum, magnesium, iron, or the like as a main component or polybutylene terephthalate.

Further, the connector window 14a is formed on the cover 14 so that the circuit board 12 is provided with power from the outside, or performs exchange of input and output signals to and from an external apparatus via the connector 15.

For example, four electronic components 11 (three on the upper surface side and one on the lower surface side) are mounted on the circuit board 12, and the circuit wiring provided on the circuit board 12 is connected to the respective electronic components 11 and is also connected to the pin terminal 15a of the connector 15.

Further, a thermal via (through-hole) 17 is provided in a portion of the circuit board 12 on which the electronic component 11 is mounted.

The thermal via 17 is provided below the electronic component 11 located at the center among the three electronic components 11 mounted on the upper surface side of the circuit board 12, a rectangular protrusion 21 protrudes from a portion of the base 13 located just below the thermal via 17, and a high thermal conductive layer 20 is interposed between the lower surface of the circuit board 12 and the upper surface of the rectangular protrusion 21 of the base 13 to come into contact with both of them. As the high thermal conductive layer 20, an adhesive, grease, a thermal radiating sheet, or the like is used here.

Further, (a main body portion of) the electronic component 11 located at the right end among the three electronic components 11 mounted on the upper surface side of the circuit board 12 is attached to float from the upper surface of the circuit board 12 by the electronic component terminals, and a gap is formed between the electronic component 11 and the circuit board 12.

In the onboard control apparatus 1 having the aforementioned configuration, the heat generated in the electronic component 11 is transferred to the base 13 via the thermal via 17 and the high thermal conductive layer 20, and is radiated from the housing 10 to the atmosphere.

In the onboard control apparatus 1 of the present embodiment, the thermal radiating coating films (31, 32, 33, and 34) are formed on specific portions such as the inside of the circuit board, the cover, the base, and the connector pins.

In this case, after the electronic component 11 and the connector 15 are mounted on the circuit board 12, the thermal radiating coating film 31 is formed (applied) on one surface and/or the other surface thereof. Further, after the base 13 and the cover 14 are manufactured in a prescribed size and shape, the thermal radiating coating films 32 and 33 are formed (coated) on the inner surface and/or the outer surface thereof. Further, on the pin terminals 15a of the connector 15, the thermal radiating coating film 34 is formed (applied) on a portion between the connection joint 15f on the circuit board 12 side and the connector housing 15b.

As a coating method, brush coating, spray coating, and immersion coating is preferable. However, electrostatic coating, curtain coating, electrodeposition coating, powder coating, and the like may be used depending on the object to be coated. In the method for coating by drying the material after coating of the material, methods such as natural drying, baking, and ultraviolet curing are preferably used. At this time, it is preferable that the thermal radiating coating film be directly coated on each base material. For example, if a thermal radiating coating film is provided on the circuit board after the surface treatment of a moisture-proof material or the like, the distance between the surface of the circuit board and the thermal radiating coating film increases. Thus, the amount of heat transfer decreases, and the thermal radiation properties decreases.

Further, FIG. 2 illustrates an example in which all of the thermal radiating coating films 31, 32, 33, and 34 are formed. From the viewpoint of improving the thermal radiation properties, it is preferable to provide the thermal radiating coating film on the plurality of surfaces, but the thermal radiating coating film is preferably provided on at least one surface of the inside of the circuit board, the cover, the base and the connector pin.

Further, the thermal radiating coating film may be configured to be coated only on a part, particularly, the heat generating component and its surroundings, without being limited to the entire surfaces of each base material surface. As a result, it is possible to reduce the amount of paint used for coating.

Next, a specific configuration of the thermal radiating coating film of this embodiment will be described. The material forming the thermal radiating coating film is not particularly limited as long as it is a material having thermal radiation properties, but it is most preferable to use a composite material made up of organic resin, and particles having excellent thermal conductivity and thermal radiation properties than organic resin.

Specific examples of the thermal radiation material will be described below.

The thermal radiation material contains thermal radiating particles, a resin, and a solvent, and there is a relation between the specific gravity of a mixture agent of a resin and a solvent ≈ the specific gravity of thermal radiating particles. The thermal radiation material makes a thermosetting resin or a thermoplastic resin a binder. The thermal radiating particles may be equal to the specific gravity of the mixture agent of the binder and the solvent. The thermal radiation material is applied and the solvent is removed from the thermal radiating coating film during curing, and the mixing specific gravity of the binder and the solvent increases. In contrast, the specific gravity of the thermal radiating particles becomes smaller, the thermal radiating particles float on the coating film surface of the thermal radiating coating film, and the surface area of the coating film increases. Materials of the thermal radiating particles are not particularly limited, but resin particles, particles obtained by thickening shells of the hollow particles, secondary particles of hollow particles and solid particles, and the like can be adopted. When insulating properties are required for an object to be coated such as a circuit board on which the electronic components of the onboard control apparatus are mounted, insulating properties are required for the thermal radiating coating film. Therefore, it is preferable to blend a material having insulating properties such as ceramic powders with the thermal radiation material for forming the thermal radiating coating film. When two or more kinds of particles are blended, it is preferable to adopt a combination in which the particles do not overlap at the absorbance of 0.5 or more in the infrared absorption region of 1200 to 500 cm⁻¹. Electromagnetic waves can be emitted at wavelengths in a wide range, and the thermal radiation performance improves. The average particle size of the particles having high thermal radiating properties is not particularly limited, but is preferably 0.1 to 300 µm. When the average particle diameter exceeds 300 µm, particles may fall off from the thermal radiating coating film and the thermal radiation performance may be degraded. When the average particle size is less than 0.1 µm, the particles are covered with the binder resin, and the thermal radiation performance may be degraded.

The shape of particles having the high thermal radiation properties can be any shape conventionally known, and is not particularly limited. However, the shape may be spherical, flake, acicular, rectangular parallelepiped, cubic, tetrahedral, hexahedral, polyhedral, tubular, and gyrations that extend in four different axis directions from the core. In particular, it is preferable to use hollow or porous particles to be made equal to the specific gravity of the mixture of the binder and solvent.

As the thermosetting resin or thermoplastic resin, conventionally known ones can be used, and there is no particular limitation. As an example, a synthetic resin or an aqueous emulsion resin can be used. Examples of the synthetic resin include synthetic resin such as phenolic resins, alkyd resins, aminoalkyd resins, urea resins, silicone resins, melamine urea resins, epoxy resins, polyurethane resins, vinyl acetate resins, acrylic resins, chlorinated rubber resins, vinyl chloride resins, and fluororesin, and an acrylic resin that is inexpensive is preferable. Further, examples of aqueous emulsions include silicone acrylic emulsions, urethane emulsions, acrylic emulsions, and the like.

The thermal radiation material preferably contains thermally conductive particles, in addition to the thermal radiating particles, the resin and the solvent. The thermally conductive particles are preferably larger than the specific gravity of the thermal radiating particles. The thermal radiation material is applied, and during the curing, the solvent is removed from the thermal radiating coating film, and the thermally conductive material is densely packed on the heat generating side of the thermal radiating coating film. As a result, the heat from the heating element can be transferred to the surface of the thermal radiating coating film by the thermally conductive particles. Further, it is possible to radiate heat from the surface of the thermal radiating coating film into the atmosphere, by the thermal radiating particles excellent in thermal radiation properties.

As the thermally conductive particles, conventionally known materials can be used. Although there are no particular limitations, it is possible to adopt ceramic powders such as boron nitride, aluminum nitride, aluminum oxide, magnesium oxide, titanium oxide, zirconia, iron oxide, copper oxide, nickel oxide, cobalt oxide, lithium oxide, titanium oxide, and silicon dioxide, metal powders such as copper, nickel, iron, and silver, carbon material, or the like, and it is preferable to blend at least one of the elements. When insulating properties are required for an object to be coated such as a circuit board on which the electronic components of the onboard control apparatus are mounted, insulating properties are required for the thermal radiating coating film. Therefore, it is preferable to blend a material having insulating properties such as ceramic powder with the thermal radiation material for forming the thermal radiating coating film.

An average particle size of the thermally conductive particles is not particularly limited, but is 0.01 to 200 µm. When the average particle diameter exceeds 200 µm, the film thickness of the coating film becomes thick, which causes a decline in thermal radiation properties, and there is a risk of decline in strength of the coating film or the adhesive strength and adhesion force to a layer to be coated may decrease. Meanwhile, if the average particle size is less than 0.01 µm, the interface between the particles and the binder increases, and there is a risk of decline in the thermal conductivity.

The shape of the thermally conductive particles can be any shape conventionally known, and is not particularly limited. However, the shape may be spherical, flake, acicular, rectangular parallelepiped, cubic, tetrahedral, hexahedral, polyhedral, cylindrical, tubular, and a three-dimensional acicular structure extending in four different axis directions from the core.

Examples of the solvent include water and an organic solvent, and are not particularly limited. Selection of the solvent is optimally determined in the combination with other materials such as thermal radiating particles and thermally conductive particles, dispersing agent, and the like. It is desirable to select a suitable solvent. As the organic solvent, organic solvents such as ketone type, alcohol type, aromatic type, and the like can be adopted. Specific examples thereof include acetone, methyl ethyl ketone, cyclohexene, ethylene glycol, propylene glycol, methyl alcohol, isopropyl alcohol, butanol, benzene, toluene, xylene, ethyl acetate, butyl acetate, and the like. These may be used singly or in combination.

In addition to the above-described components, the thermal radiation material may further include other components as necessary. Examples of the component include a dispersing agent, a film-forming aid, a plasticizer, a pigment, a silane coupling agent, a viscosity adjusting agent, and the like. As the above-mentioned components, conventional ones can be used, and there is no particular limitation.

The method for coating the thermal radiation material is not particularly limited, and the method can be selected depending on the purpose from the commonly used coating methods. Specifically, brush coating, spray coating, roll coater coating, immersion coating, and the like can be adopted. In the method for forming the coating film by drying after coating of the thermal radiation material, it is possible to use methods such as natural drying, baking, ultraviolet curing, and the like, and the methods are selected depending on the properties of the paint.

Further, although the average thickness of the thermal radiating coating film is not particularly limited and can be selected according to the purpose, the average thickness is preferably 200 µm or less, and more preferably, is 1 µm to 200 µm. When the thermal radiating coating film is 200 µm or more, the coating film serves as a heat insulating layer, and there is a risk of a decline in thermal radiating properties. In addition, when the thickness is 1 µm or less, there is a risk of a failure in sufficient exhibition of the thermal radiating effect. Further, from the viewpoint of thermal radiating properties, the thermal radiating coating film preferably has a thermal radiating ratio of 0.8 or more for each wavelength in the wavelength region of 2.5 µm to 20 µm, and more preferably, the thermal radiating ratio is as close to 1 as possible.

The thermal conductivity can be determined by specifying a binder resin by an analysis method such as an infrared spectroscopy (IR) or a gas chromatography analysis (GCMS), by specifying the particles in the cross-section of the thermal radiating coating film by a scanning electron microscope-energy dispersive X-ray analysis method (SEM-EDX) or the like, by blending the respective particles, and by measuring the thermal conductivity of the formed film.

The thermal conductivity was determined by forming the film of the adjusted material by 200 µm, by calculating the thermal diffusivity using the temperature wave number analysis method, and by multiplying the thermal diffusivity, the specific gravity, and the specific heat.

The thermal radiating properties can be obtained by specifying a binder resin using an analysis method such as an infrared spectroscopy (IR) or a gas chromatograph analysis method (GCMS), by specifying the particles on the cross-section of the thermal radiating coating film through an element analysis such as a scanning electron microscope-energy dispersive X-ray analysis method (SEM-EDX), by blending the respective particles, and by measuring the radiation ratio of the formed film.

In the radiation ratio measuring method, after the prepared material is applied to an aluminum plate having a size of 100 mm × 100 mm and a thickness of 1 mm at around 30 µm using an application coater, the radiation ratio of the cured sample was measured at room temperature, using D and S AERD manufactured by Kyoto Electronics Manufacturing Co., Ltd.

Next, an example of the assembling process of the onboard control apparatus will be described.

The electronic component is mounted on a circuit board by solder. After the process of assembling the connector pins to the connector housing, the connector pins and the circuit board are joined together by solder in a spot flow process or the like. After the electronic component and the connector are mounted on the circuit board, the thermal radiation material is applied to provide the thermal radiating coating film. As a coating method, coating such as brush coating, spray coating, and immersion coating is preferable. However, electrostatic coating, curtain coating, electrodeposition coating, powder coating, or the like may be used, depending on the object to be coated. In the method for drying the thermal radiation material to form a coating film after applying the thermal radiation material, a method such as natural drying or baking is preferably used.

The cover is manufactured by casting, pressing or cutting, using an alloy containing aluminum, magnesium, iron, or the like as a main component or a resin material such as polybutylene terephthalate. The shape of the cover is set such that the bottom surface is open and a connector window is provided. After forming the cover, a thermal radiating coating film is provided. As the coating method of the thermal radiation material, coating such as brush coating, spray coating, immersion coating is preferable. However, electrostatic coating, curtain coating, electrodeposition coating, powder coating, and the like may be used, depending on the object to be coated. In the method for drying the thermal radiation material to form a coating film after applying the thermal radiation material, a method such as natural drying or baking is preferably used.

The base is manufactured by casting, pressing or cutting using an alloy containing aluminum, magnesium, iron, or the like as a main component or a resin material such as polybutylene terephthalate. The shape of the base is formed on a substantially flat plate so as to close the bottom opening of the cover. After forming the base, the thermal radiating coating film is formed. As the coating method of the thermal radiation material, coating such as brush coating, spray coating, and immersion coating is preferable. However, electrostatic coating, curtain coating, electrodeposition coating, powder coating, and the like may be used depending on the object to be coated. In the method for drying the thermal radiation material to form a coating film after applying the thermal radiation material, methods such as natural drying, baking, and ultraviolet curing are preferably used.

The film thickness of each thermal radiating coating film is about 1 µm to 200 µm, and preferably, the film thickness is 20 µm to 40 µm. If the film thickness is too thicker than 40 µm, the absorbed heat is blocked, and if film thickness is too thinner than 20 µm, the thermal radiation performance is degraded. Therefore, the amount of heat transfer from the high temperature portion such as the heating element to the outside of the housing decreases.

Hereinafter, the present invention will be described in detail using examples. Component materials constituting the materials used in the examples and comparative examples are as follows.

### (Binder)

COATAX LH-404: manufactured by Toray Fine Chemical Co., Ltd.

### (Particles)

ARX-15: resin particles manufactured by SEKISUI PLASTICS CO., Ltd., particle size 16.8 µm
SI007PB: silicon dioxide manufactured by Kojundo Chemical Laboratory Co., Ltd., particle diameter 0.8 µm
S42XHS: hollow silica manufactured by Sumitomo 3M Ltd., true density 0.42 g/cm³ WZ-501
: Zinc oxide single crystal Panatetra manufactured by AMTEC Corporation, average fiber length 10 µm

In preparation of the sample, the particles, resin and solvent were added to adjust the viscosity, and then were mixed using a hybrid mixer.

The thermal radiation evaluation method in the example is as follows.

### (Thermal radiation evaluation method)

Planar heating element Polyimide heater FL-HEAT No. 6 (Shinwa Rules Co., Ltd.) is sandwiched between aluminum plates (50 mm × 80 mm, t: 2 mm). A thermocouple is bonded to the surface of the aluminum plate with solder for the aluminum plate. A prepared sample was coated on the surface of the aluminum plate and heated and dried at 60°C for 30 minutes to form a coating having a thickness of 30 µm. The sample was allowed to stand at the center of the thermostat set at 25°C, 6W was applied to the heater, and the temperature change on the surface of the aluminum plate was measured. Since the heater generates a certain amount of heat, the higher the thermal radiating effect of the thermal radiation material is, the lower the temperature of the heater or the aluminum plate surface temperature is. That is, the lower the temperature of the heater or the surface temperature of the aluminum plate is, the higher the thermal radiation effect is.

### Example 1

The resin particles of 5 w% were placed in a container, mixed with COATAX LH-404 using a hybrid mixer and adjusted. The mixture was coated on an aluminum plate by brush coating and heated and dried at 60°C for 30 minutes to form a thermal radiating coating film so that the film thickness became 30 µm.

### Example 2

The resin particles of 5 w% and the zinc oxide single crystal Panatetra of 5 w% were placed in a container, mixed with COATAX LH-404 using a hybrid mixer and adjusted. The mixture was coated on an aluminum plate by brush coating and heated and dried at 60°C for 30 minutes to form a thermal radiating coating film so that the film thickness became 30 µm.

### Example 3

The particles of 5 w% having thickened shells of hollow silica were placed on a container, mixed with COATAX LH-404 using a hybrid mixer and adjusted. The mixture was coated on an aluminum plate by brush coating and heated and dried at 60°C for 30 minutes to form a thermal radiating coating film so that the film thickness became 30 µm.

### Example 4

Particles of 5 w% having thickened shells of hollow silica and zinc oxide single crystal Panatetra of 5 w% were placed on a container, mixed with COATAX LH-404 using a hybrid mixer and adjusted. The mixture was coated on an aluminum plate by brush coating and heated and dried at 60°C for 30 minutes to form a thermal radiating coating film so that the film thickness became 30 µm.

### Example 5

Secondary particles of 5 w% having solid particles adhered to the periphery of the hollow silica particles were placed on a container, mixed with COATAX LH-404 using a hybrid mixer and adjusted. The mixture was coated on an aluminum plate by brush coating and heated and dried at 60°C for 30 minutes to form a thermal radiating coating film so that the film thickness became 30 µm.

### Example 6

Secondary particles of 5 w% having solid particles adhered to the periphery of the hollow particles and zinc oxide single crystal Panatetra of 5w% were placed on a container, mixed with COATAX LH-404 using a hybrid mixer and adjusted. The mixture was coated on an aluminum plate by brush coating and heated and dried at 60°C for 30 minutes to form a thermal radiating coating film so that the film thickness became 30 µm.

### Example 7

Secondary particles of 5 w% having hollow particles adhered to the periphery of solid particles were placed on a container, mixed with COATAX LH-404 using a hybrid mixer and adjusted. The mixture was coated on an aluminum plate by brush coating and heated and dried at 60°C for 30 minutes to form a thermal radiating coating film so that the film thickness became 30 µm.

### Example 8

Secondary particles of 5 w% having hollow particles adhered to the periphery of the solid particles and zinc oxide single crystal Panatetra of 5 w% were placed on a container, mixed with COATAX LH-404 using a hybrid mixer and adjusted. The mixture was coated on an aluminum plate by brush coating and heated and dried at 60°C for 30 minutes to form a thermal radiating coating film so that the film thickness became 30 µm.

### (Comparative Example 1)

COATAX LH-404 was coated on an aluminum plate by brush coating and heated and dried at 60°C for 30 minutes to form a coating film so that a film thickness became 30 µm.

### (Comparative Example 2)

SIO07PB silica 5 w% was placed on a container and mixed with COATAX LH-404 using a hybrid mixer, and the mixture was coated on an aluminum plate by brush coating, and heated and dried at 60°C for 30 minutes to form a thermal radiating coating film so that the film thickness became 30 µm.

### (Comparative Example 3)

HS42XHS hollow silica of 5w% was placed on a container, and mixed with COATAX LH-404 using a hybrid mixer, and the mixture was coated on an aluminum plate by brush coating, and heated and dried at 60°C for 30 minutes to form a thermal radiating coating film so that a film thickness became 30 µm.

The constitutions of the thermal radiation materials of Examples 1, 2, 3, 4, 5, 6, 7, and 8, and Comparative Examples 1 and 2, and the thermal radiation effect are illustrated in Table 1. Further, the unit of the numerical value in the table is a volume part, and "-" indicates a non-blended state. From the results of Table 1, by including a thermal radiating coating film having a specific gravity larger in the order of thermal radiating particles ≈ resin < thermal conductive particles, which is the constitution of this example, coatability improves, an amount of heat transfer from a heating element increases, and the thermal radiation properties improve. Therefore, it is suitable for an onboard control apparatus such as an ECU.

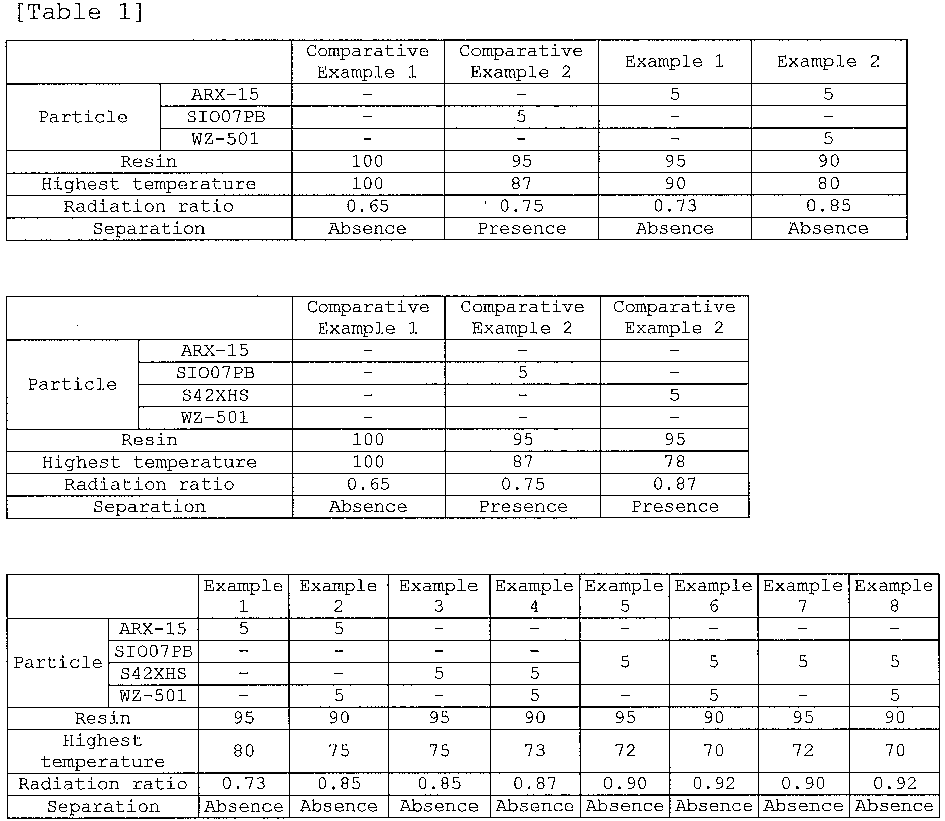

- 1: onboard control apparatus
- 11: electronic components
- 12: circuit board
- 13: base
- 14: cover
- 15: connector
- 16: pedestal
- 17: screw
- 18: vehicle-mounted fixed part
- 19: thermal via
- 20: high thermal conductive layer
- 31, 32, 33, 34: thermal radiating coating film
- 41: connector pin
- 51: base material
- 52: binder resin
- 53: thermally conductive particles
- 54: thermal radiating particles

## Claims

1. An onboard control apparatus comprising:
a circuit board stored in a housing;
an electronic component mounted on the circuit board; and
a thermal radiating coating film which is disposed on the electronic component to radiate heat generated from the electronic components,
wherein the thermal radiating coating includes a resin and thermal radiating particles which radiate heat, and the thermal radiating particles and the resin have substantially same specific gravity.

2. The onboard control apparatus according to claim 1, wherein the thermal radiating coating film has specific gravity of thermal radiating particles ≈ resin.

3. The onboard control apparatus according to claim 1, wherein the thermal radiating coating film further contains a thermally conductive resin, and specific gravity is larger in the order of thermal radiating particles ≈ resin < thermally conductive particles.

4. The onboard control apparatus according to claim 1, wherein the thermal radiating particles are exposed from a surface of the thermal radiating coating film to form irregularities on the surface of the film.

5. The onboard control apparatus according to claim 1, wherein the thermal radiating coating film is a cured product of a thermal radiation material containing thermal radiating particles, a resin, and a solvent, and the thermal radiation material is configured such that the thermal radiating particles, the resin, and the solvent are uniformly mixed and are not separated.

6. The onboard control apparatus according to claim 5, wherein the thermal radiation material further contains thermally conductive particles which are uniformly mixed and are not separated.

7. The onboard control apparatus according to claim 5 or 6, wherein the resin is a thermosetting resin or a thermoplastic resin, specific gravity of the resin and the solvent mixed ≈ specific gravity of the thermal radiating particles, and the thermal radiating particles contain at least one of resin particles, particles obtained by thickening shells of hollow particles, and secondary particles of hollow particles and solid particles.
